(19) **Europäisches Patentamt / European Patent Office / Office européen des brevets**

(11) **EP 4 763 920 A1**

(12) **EUROPEAN PATENT APPLICATION**
published in accordance with Art. 153(4) EPC

(43) Date of publication:
**24.06.2026 Bulletin 2026/26**

(21) Application number: **24859377.4**

(22) Date of filing: **06.08.2024**

(51) International Patent Classification (IPC):
*C08L 83/04* (2006.01)    *C08K 3/36* (2006.01)
*C08K 5/14* (2006.01)     *C08L 83/07* (2006.01)
*C08L 101/04* (2006.01)   *C09K 3/10* (2006.01)
*F16J 15/10* (2006.01)    *H01L 21/3065* (2006.01)

(52) Cooperative Patent Classification (CPC):
**C08K 3/36; C08K 5/14; C08L 83/04; C08L 101/04;
C09K 3/10; F16J 15/10; H10P 50/242**

(86) International application number:
**PCT/JP2024/028073**

(87) International publication number:
**WO 2025/047337 (06.03.2025 Gazette 2025/10)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **28.08.2023 JP 2023137995**

(71) Applicant: **Mitsubishi Cable Industries, Ltd.
Chiyoda-ku
Tokyo 100-8303 (JP)**

(72) Inventors:
• **IEZUMI, Naofumi
  Amagasaki-shi, Hyogo 660-0856 (JP)**

• **KOBIKI, Kazuhiko
  Amagasaki-shi, Hyogo 660-0856 (JP)**
• **MUKAI, Hiroshi
  Amagasaki-shi, Hyogo 660-0856 (JP)**
• **YAMAMOTO, Tetsuya
  Arida-shi, Wakayama 649-0304 (JP)**
• **ITO, Takao
  Amagasaki-shi, Hyogo 660-0856 (JP)**
• **TOMITA, Mitsuhiro
  Amagasaki-shi, Hyogo 660-0856 (JP)**

(74) Representative: **Germain Maureau
  12, rue Boileau
  69006 Lyon (FR)**

(54) **UNCROSSLINKED RUBBER COMPOSITION AND RUBBER MOLDED ARTICLE USING SAME**

(57)     An uncrosslinked rubber composition includes: a base rubber mainly composed of a silicone rubber; a perfluoro-skeleton compound having an ethylenically unsaturated bond; and a first silica. The mass ratio of the amount of the perfluoro-skeleton compound to the amount of the first silica is less than 5.

EP 4 763 920 A1

**Description**

TECHNICAL FIELD

The present invention relates to uncrosslinked rubber compositions and rubber molded articles using the same.

BACKGROUND ART

Silicone rubber compositions are used in many applications because they have excellent electrical insulation properties, heat resistance, cold resistance, etc. For example, Patent Document 1 discloses the use of a rubber composition obtained by mixing a silicone rubber composition and a perfluoropolyether-based fluororubber composition as a seal etc. Patent Document 2 discloses the use of a silicone rubber composition containing an alkenyl-group-containing organopolysiloxane, an alkenyl-group-containing perfluoropolyether, and an organohydropolysiloxane for automotive rubber parts etc.

CITATION LIST

PATENT DOCUMENT

PATENT DOCUMENT 1: Japanese Patent No. 5083489
PATENT DOCUMENT 2: Japanese Unexamined Patent Publication No. H11-5902

SUMMARY OF THE INVENTION

The present invention provides an uncrosslinked rubber composition including: a base rubber mainly composed of a silicone rubber; a perfluoro-skeleton compound having an ethylenically unsaturated bond; and a first silica. The mass ratio of the amount of the perfluoro-skeleton compound to the amount of the first silica is less than 5.
The present invention also provides a rubber molded article obtained by molding the uncrosslinked rubber composition according to the present invention into a predetermined shape and crosslinking the molded composition.

DESCRIPTION OF EMBODIMENTS

Hereinafter, an embodiment will be described in detail.
The uncrosslinked rubber composition according to the embodiment contains a base rubber A mainly composed of a silicone rubber, a perfluoro-skeleton compound B having an ethylenically unsaturated bond, and a first silica C. In the uncrosslinked rubber composition, the mass ratio of the amount of the perfluoro-skeleton compound B to the amount of the first silica C is less than 5.
With such an uncrosslinked rubber composition of the embodiment, a rubber molded article having excellent plasma resistance can be obtained.
In the present application, the "first silica" refers to a silica that, together with the perfluoro-skeleton compound B, is mixed with the base rubber A to form the uncrosslinked rubber composition. The "second silica," which will be described later, refers to a silica that is mixed in advance with a silicone rubber to form a rubber compound X.
The base rubber A is mainly composed of a silicone rubber. Therefore, the content of the silicone rubber in the base rubber A is more than 50 mass%, and from the viewpoint of obtaining a rubber molded article having excellent plasma resistance, suitably 80 mass% or more, more suitably 90 mass% or more, and even more suitably 100 mass%. The base rubber A may contain, for example, a fluororubber etc. in addition to the silicone rubber.
Examples of the silicone rubber include millable silicone rubbers such as phenyl vinyl methyl silicone rubber (PVMQ), vinyl methyl silicone rubber (VMQ), fluorosilicone rubber (FVMQ), and dimethyl silicone rubber (MQ). The silicone rubber suitably includes one or more of these, and from the viewpoint of obtaining a rubber molded article having excellent plasma resistance and low-temperature flexibility, more suitably includes phenyl vinyl methyl silicone rubber (PVMQ).
The uncrosslinked rubber composition according to the embodiment may be prepared using a rubber compound X in which a second silica is mixed in advance with the above silicone rubber. In the rubber compound X, the second silica is dispersed in the silicone rubber. Examples of the second silica include a dry-process silica and a wet-process silica. The content of the second silica in the rubber compound X is, for example, 20 mass% or more and 40 mass% or less. Examples of commercially available materials for the rubber compound X include, for example, KE-186-U manufactured by Shin-Etsu Chemical Co., Ltd.

The perfluoro-skeleton compound B is uniformly mixed with the base rubber A. Examples of the perfluoro-skeleton compound B include compounds having a perfluoropolyether structure and compounds having a perfluoroalkylene structure. From the viewpoint of obtaining a rubber molded article having excellent plasma resistance, the perfluoro-skeleton compound B suitably includes a compound having a perfluoropolyether structure.

Examples of functional groups containing an ethylenically unsaturated bond in the perfluoro-skeleton compound B include a vinyl group, an allyl group, a propargyl group, a butenyl group, and an ethynyl group. From the viewpoint of obtaining a rubber molded article having excellent plasma resistance, the functional group containing an ethylenically unsaturated bond is suitably a vinyl group. From the same viewpoint, the perfluoro-skeleton compound B suitably has two or more functional groups containing an ethylenically unsaturated bond.

From the viewpoint of obtaining a rubber molded article having excellent plasma resistance, the perfluoro-skeleton compound B suitably includes a one-component liquid material, and more suitably includes a one-component liquid material having a viscosity at 23°C of 350 Pa·s or more and 450 Pa·s or less.

Examples of commercially available materials for the perfluoro-skeleton compound B include the SIFEL 3000 series manufactured by Shin-Etsu Chemical Co., Ltd. From the viewpoint of obtaining a rubber molded article having excellent plasma resistance, the commercially available materials for the perfluoro-skeleton compound B suitably include a one-component liquid material among the SIFEL 3000 series, more suitably include a one-component liquid material among the SIFEL 3000 series that has a viscosity at 23°C of 350 Pa·s or more and 450 Pa·s or less, and even more suitably include X-71-369-N.

In a case where the rubber compound X composed of the silicone rubber and the second silica is used, the amount of the perfluoro-skeleton compound B in the uncrosslinked rubber composition according to the embodiment is, from the viewpoint of obtaining a rubber molded article having excellent plasma resistance, suitably 3 parts by mass or more and 40 parts by mass or less, more suitably 5 parts by mass or more and 30 parts by mass or less, and even more suitably 10 parts by mass or more and 25 parts by mass or less, per 100 parts by mass of the rubber compound X.

The first silica C is dispersed in a uniform mixture of the base rubber A and the perfluoro-skeleton compound B. Examples of the first silica C include a dry-process silica and a wet-process silica. Examples of the dry-process silica include a fumed silica. Examples of the wet-process silica include a precipitated silica and a gel-process silica. From the viewpoint of obtaining a rubber molded article having excellent plasma resistance, the first silica C suitably includes a dry-process silica, and more suitably includes a fumed silica.

The first silica C may include a non-surface-treated hydrophilic silica. From the viewpoint of obtaining a rubber molded article having excellent plasma resistance, the primary particle diameter of the hydrophilic silica is suitably 5 nm or more and 20 nm or less, and more suitably 10 nm or more and 15 nm or less. From the same viewpoint, the BET specific surface area of the hydrophilic silica is, for example, 150 $m^2/g$ or more and 200 $m^2/g$ or less, or 175 $m^2/g$ or more and 225 $m^2/g$ or less.

The first silica C may include a hydrophobic silica surface-treated with a surface treatment agent. Examples of the surface treatment agent include dimethyldichlorosilane, hexamethyldisilazane, octylsilane, and silicone oil. From the viewpoint of obtaining a rubber molded article having excellent plasma resistance, the hydrophobic silica suitably includes one surface-treated with dimethyldichlorosilane. From the same viewpoint, the primary particle diameter of the hydrophobic silica is suitably 10 nm or more and 25 nm or less, and more suitably 15 nm or more and 20 nm or less. From the same viewpoint, the BET specific surface area of the hydrophobic silica is, for example, 50 $m^2/g$ or more and 150 $m^2/g$ or less, or 90 $m^2/g$ or more and 130 $m^2/g$ or less.

In the case where the rubber compound X composed of the silicone rubber and the second silica is used, the amount of the first silica C in the uncrosslinked rubber composition according to the embodiment is, from the viewpoint of obtaining a rubber molded article having excellent plasma resistance, suitably 2 parts by mass or more and 25 parts by mass or less, more suitably 3 parts by mass or more and 15 parts by mass or less, and even more suitably 4 parts by mass or more and 10 parts by mass or less, per 100 parts by mass of the rubber compound X.

From the viewpoint of obtaining a rubber molded article having excellent plasma resistance, the mass ratio of the amount of the perfluoro-skeleton compound B to the amount of the first silica C in the uncrosslinked rubber composition according to the embodiment is suitably 1.5 or more and 4.5 or less, and more suitably 2 or more and 4 or less.

The uncrosslinked rubber composition according to the embodiment may further contain an organic peroxide D as a thermal crosslinking agent. Examples of the organic peroxide D include dialkyl peroxides, peroxyketals, and peroxyesters. Examples of the dialkyl peroxides include 2,5-dimethyl-2,5-bis(t-butylperoxy)hexane, dicumyl peroxide, and 1,3-di(t-butylperoxy)diisopropylbenzene. Examples of the peroxyketals include 1,1-di(t-hexylperoxy)cyclohexane, 1,1-di(t-butylperoxy)cyclohexane, and n-butyl-4,4-di(t-butylperoxy)valerate. Examples of the peroxyesters include 2,5-dimethyl-2,5-di(benzoylperoxy)hexane, t-hexyl peroxybenzoate, and t-butyl peroxybenzoate. The organic peroxide D suitably includes one or more of these, and from the viewpoint of obtaining a rubber molded article having excellent plasma resistance, suitably includes a dialkyl peroxide, and more suitably includes 2,5-dimethyl-2,5-bis(t-butylperoxy)hexane.

In the case where the rubber compound X composed of the silicone rubber and the second silica is used, the amount of the organic peroxide D as a thermal crosslinking agent in the uncrosslinked rubber composition according to the embodiment is, from the viewpoint of obtaining a rubber molded article having excellent plasma resistance, suitably 0.5 parts by mass or more and 5 parts by mass or less, and more suitably 1 part by mass or more and 3 parts by mass or less, per 100 parts by mass of the rubber compound X.

The uncrosslinked rubber composition according to the embodiment may contain rubber compounding agents such as a plasticizer, a processing aid, and an antioxidant, but from the viewpoint of suppressing dust generation when exposed to a plasma atmosphere, it suitably does not contain carbon black.

The uncrosslinked rubber composition according to the embodiment can be prepared by kneading the base rubber A mainly composed of a silicone rubber, the perfluoro-skeleton compound B, the first silica C, and other rubber compounding agents using a known rubber kneading machine such as a Banbury mixer, a kneader, or an open roll. At this time, the rubber compound X composed of the silicone rubber and the second silica may be used.

The uncrosslinked rubber composition according to the embodiment can be molded into a predetermined shape and crosslinked to form a rubber molded article of a rubber composition. At this time, crosslinking of the uncrosslinked rubber composition may be only primary crosslinking in which the uncrosslinked rubber composition is heated and pressurized by, for example, press molding. Alternatively, secondary crosslinking may be combined in which a primary crosslinked product is heated at a higher temperature and for a longer time than in the primary crosslinking by, for example, a Geer oven. Furthermore, radiation crosslinking may be combined in which the secondary crosslinked product is irradiated with radiation.

Examples of the rubber molded article include seals such as an O-ring. From the viewpoint of obtaining excellent plasma resistance, the rubber molded article is suitably a seal for a semiconductor manufacturing apparatus.

The hardness Hs of the rubber composition forming the rubber molded article is suitably A50 or more and A90 or less, more suitably A60 or more and A80 or less, and even more suitably A70 or more and A80 or less. This hardness Hs is measured as an instantaneous value at the moment when a pressure plate contacts a test piece using a Type A durometer in accordance with JIS K 6253-3:2012.

The tensile strength Tb of the rubber composition forming the rubber molded article is suitably 7 MPa or more, and more suitably 8 MPa or more. The elongation Eb is suitably 150% or more, and more suitably 250% or more. The tensile stress at 100% elongation S100 is suitably 1.5 MPa or more and 4 MPa or less, and more suitably 2 MPa or more and 2.5 MPa or less. The tensile strength Tb, the elongation Eb, and the tensile stress at 100% elongation S100 are measured using a dumbbell-shaped No. 3 test piece in accordance with JIS K 6251:2017.

Examples

(Uncrosslinked Rubber Compositions)

Uncrosslinked rubber compositions of Examples 1 to 11 and Comparative Examples 1 to 7 were prepared as follows. Their compositions are also shown in Tables 1 and 2.

<Example 1>

An uncrosslinked rubber composition was prepared by mixing and kneading, per 100 parts by mass of a rubber compound X (KE-186-U, manufactured by Shin-Etsu Chemical Co., Ltd.) composed of phenyl vinyl methyl silicone rubber (PVMQ-X) as the base rubber A and the second silica, 5 parts by mass of a compound having a perfluoropolyether structure as the perfluoro-skeleton compound B (X-71-369-N, manufactured by Shin-Etsu Chemical Co., Ltd., one-component liquid material, viscosity (23°C): 410 Pa·s), 3 parts by mass of a hydrophilic silica as the first silica C (AEROSIL 200, manufactured by NIPPON AEROSIL CO., LTD., non-surface-treated dry-process silica, primary particle diameter: 12 nm, BET specific surface area: 200 $m^2$/g), and 2 parts by mass of 2,5-dimethyl-2,5-bis(t-butylperoxy)hexane as the organic peroxide D (C-8, manufactured by Shin-Etsu Chemical Co., Ltd.). This uncrosslinked rubber composition was designated as Example 1.

<Example 2>

An uncrosslinked rubber composition having the same composition as Example 1 was prepared, except that the amount of the hydrophilic silica as the first silica C was changed to 5 parts by mass per 100 parts by mass of the rubber compound X. This uncrosslinked rubber composition was designated as Example 2.

<Example 3>

An uncrosslinked rubber composition having the same composition as Example 2 was prepared, except that the amount of the compound having a perfluoropolyether structure as the perfluoro-skeleton compound B was changed to 10 parts by mass per 100 parts by mass of the rubber compound X. This uncrosslinked rubber composition was designated as Example 3.

<Example 4>

An uncrosslinked rubber composition having the same composition as Example 2 was prepared, except that the amount of the compound having a perfluoropolyether structure as the perfluoro-skeleton compound B was changed to 20 parts by mass per 100 parts by mass of the rubber compound X. This uncrosslinked rubber composition was designated as Example 4.

<Example 5>

An uncrosslinked rubber composition having the same composition as Example 4 was prepared, except that the amount of the hydrophilic silica as the first silica C was changed to 8 parts by mass per 100 parts by mass of the rubber compound X. This uncrosslinked rubber composition was designated as Example 5.

<Example 6>

An uncrosslinked rubber composition having the same composition as Example 4 was prepared, except that the amount of the hydrophilic silica as the first silica C was changed to 15 parts by mass per 100 parts by mass of the rubber compound X. This uncrosslinked rubber composition was designated as Example 6.

<Example 7>

An uncrosslinked rubber composition having the same composition as Example 2 was prepared, except that, instead of the hydrophilic silica, a hydrophobic silica (AEROSIL R972, manufactured by NIPPON AEROSIL CO., LTD., dry-process silica surface-treated with dimethyldichlorosilane, primary particle diameter: 16 nm, BET specific surface area: 130 $m^2$/g) was used as the first silica C. This uncrosslinked rubber composition was designated as Example 7.

<Example 8>

An uncrosslinked rubber composition having the same composition as Example 7 was prepared, except that the amount of the compound having a perfluoropolyether structure as the perfluoro-skeleton compound B was changed to 10 parts by mass per 100 parts by mass of the rubber compound X. This uncrosslinked rubber composition was designated as Example 8.

<Example 9>

An uncrosslinked rubber composition having the same composition as Example 7 was prepared, except that the amount of the compound having a perfluoropolyether structure as the perfluoro-skeleton compound B was changed to 20 parts by mass per 100 parts by mass of the rubber compound X. This uncrosslinked rubber composition was designated as Example 9.

<Example 10>

An uncrosslinked rubber composition having the same composition as Example 2 was prepared, except that, instead of the rubber compound X, a rubber compound Y (KE-183-U, manufactured by Shin-Etsu Chemical Co., Ltd.) composed of phenyl vinyl methyl silicone rubber (PVMQ-Y) as the base rubber A and the second silica was used. This uncrosslinked rubber composition was designated as Example 10.

<Example 11>

An uncrosslinked rubber composition having the same composition as Example 10 was prepared, except that the amount of the compound having a perfluoropolyether structure as the perfluoro-skeleton compound B was changed to 20 parts by mass per 100 parts by mass of the rubber compound Y. This uncrosslinked rubber composition was designated as Example 11.

<Comparative Example 1>

An uncrosslinked rubber composition having the same composition as Examples 1 to 9 was prepared, except that the perfluoro-skeleton compound B and the first silica C were not added. This uncrosslinked rubber composition was designated as Comparative Example 1.

<Comparative Example 2>

An uncrosslinked rubber composition having the same composition as Comparative Example 1 was prepared, except that 5 parts by mass of carbon black (Thermax N990, manufactured by Cancarb Limited) was added per 100 parts by mass of the rubber compound X. This uncrosslinked rubber composition was designated as Comparative Example 2.

<Comparative Example 3>

An uncrosslinked rubber composition having the same composition as Comparative Example 2 was prepared, except that 5 parts by mass of the compound having a perfluoropolyether structure as the perfluoro-skeleton compound B was added per 100 parts by mass of the rubber compound X. This uncrosslinked rubber composition was designated as Comparative Example 3.

<Comparative Example 4>

An uncrosslinked rubber composition having the same composition as Comparative Example 3 was prepared, except that the amount of the compound having a perfluoropolyether structure as the perfluoro-skeleton compound B was changed to 10 parts by mass per 100 parts by mass of the rubber compound X. This uncrosslinked rubber composition was designated as Comparative Example 4.

<Comparative Example 5>

An uncrosslinked rubber composition having the same composition as Comparative Example 3 was prepared, except that the amount of the compound having a perfluoropolyether structure as the perfluoro-skeleton compound B was changed to 20 parts by mass per 100 parts by mass of the rubber compound X. This uncrosslinked rubber composition was designated as Comparative Example 5.

<Comparative Example 6>

An uncrosslinked rubber composition having the same composition as Example 2 was prepared, except that the amount of the hydrophilic silica as the first silica C was changed to 1 part by mass per 100 parts by mass of the rubber compound X. This uncrosslinked rubber composition was designated as Comparative Example 6.

<Comparative Example 7>

An uncrosslinked rubber composition having the same composition as Example 10 was prepared, except that the perfluoro-skeleton compound B was not added. This uncrosslinked rubber composition was designated as Comparative Example 7.

[Table 1]

| | | Examples | | | | | | | | | | |
|---|---|---|---|---|---|---|---|---|---|---|---|---|
| | | 1 | 2 | 3 | 4 | 5 | 6 | 7 | 8 | 9 | 10 | 11 |
| Rubber Compound X <Base Rubber A (PVMQ-X) + Second Silica> | | 100 | 100 | 100 | 100 | 100 | 100 | 100 | 100 | 100 | | |
| Rubber Compound Y <Base Rubber A (PVMQ-Y) + Second Silica> | | | | | | | | | | | 100 | 100 |
| Perfluoro-Skeleton Compound B | | 5 | 5 | 10 | 20 | 20 | 20 | 5 | 10 | 20 | 5 | 20 |
| First Silica C: Hydrophilic Silica | | 3 | 5 | 5 | 5 | 8 | 15 | | | | 5 | 5 |
| First Silica C: Hydrophobic Silica | | | | | | | | 5 | 5 | 5 | | |
| Organic Peroxide D | | 2 | 2 | 2 | 2 | 2 | 2 | 2 | 2 | 2 | 2 | 2 |
| B/C | | 1.67 | 1 | 2 | 4 | 2.5 | 1.3 | 1 | 2 | 4 | 1 | 4 |
| Hardness Hs | | 73 | 77 | 76 | 73 | 73 | 89 | 73 | 71 | 70 | 55 | 52 |
| Tensile Properties | Tb MPa | 10.0 | 10.2 | 10.3 | 8.2 | 9.4 | 7.1 | 11.1 | 10.9 | 10.2 | 10.0 | 10.0 |
| | Eb % | 312 | 310 | 343 | 295 | 435 | 160 | 525 | 513 | 550 | 530 | 570 |
| | S100 MPa | 2.3 | 2.4 | 2.4 | 2.2 | 2.3 | 3.7 | 1.9 | 2.0 | 2.1 | 1.3 | 1.2 |
| Plasma Resistance | Dust Generation | None | None | None | None | None | None | None | None | None | None | None |
| | Mass Loss Ratio | 1.04 | 0.99 | 1.01 | 0.81 | 0.75 | 1.08 | 1.02 | 1.06 | 0.81 | 0.98 | 0.92 |
| | | A | A | A | A | A | A | A | A | A | A | A |

[Table 2]

| | Comparative Examples | | | | | | |
|---|---|---|---|---|---|---|---|
| | 1 | 2 | 3 | 4 | 5 | 6 | 7 |
| Rubber Compound X <Base Rubber A (PVMQ-X) + Second Silica> | 100 | 100 | 100 | 100 | 100 | 100 | |
| Rubber Compound Y <Base Rubber A (PVMQ-Y) + Second Silica> | | | | | | | 100 |
| Perfluoro-skeleton Compound B | | | 5 | 10 | 20 | 5 | |
| First Silica C: Hydrophilic Silica | | | | | | 1 | 5 |
| Organic Peroxide D | 2 | 2 | 2 | 2 | 2 | 2 | 2 |
| Carbon Black | | 5 | 5 | 5 | 5 | | |
| B/C | | | | | | 5 | |
| Hardness Hs | 66 | 69 | 68 | 67 | 66 | 68 | 43 |
| Tensile Properties — Tb MPa | 11.8 | 9.3 | 10.1 | 9.6 | 8.8 | 10 | 10 |
| Tensile Properties — Eb % | 525 | 440 | 501 | 475 | 493 | 482 | 600 |
| Tensile Properties — S100 MPa | 1.7 | 1.9 | 1.8 | 1.8 | 1.7 | 1.8 | 0.6 |
| Plasma Resistance — Dust Generation | None | Present | Present | Present | Present | None | None |
| Plasma Resistance — Mass Loss Ratio | 1.41 | 1.25 | 1.2 | 1.32 | 1.14 | 1.12 | 1.1 |
| | B | B | B | B | B | B | B |

(Test Methods and Results)

Test pieces of rubber compositions obtained by crosslinking the above uncrosslinked rubber compositon were prepared, and the following tests were carried out using these test pieces. The results are shown in Table 1 and 2.

<Hardness>

Each of the uncrosslinked rubber compositions of Examples 1 to 11 and Comparative Example 1 to 7 was subjected to primary crosslinking and secondary crosslinking to prepare a sheet-like rubber composition having a thickness of 2 mm. The primary crosslinking conditions were press molding at 165°C for 5 minutes, and the secondary crosslinking conditions were heating in a Geer oven at 200°C for 4 hours (the same applies hereinafter). Three sheets of the sheet-like rubber composition were stacked to form a test piece, and the hardness Hs was measured as an instantaneous value at the moment when a pressure plate contacted the test piece using a Type A durometer in accordance with JIS K 6253-3:2023.

<Tensile Properties>

Each of the uncrosslinked rubber compositions of Examples 1 to 11 and Comparative Examples 1 to 7 was subjected to primary crosslinking and secondary crosslinking to prepare a dumbbell-shaped No. 3 test piece of a rubber composition. The tensile strength Tb, elongation Eb, and tensile stress at 100% elongation S100 of each test piece were measured in accordance with JIS K 6251:2017.

<Plasma Resistance>

Each of the uncrosslinked rubber compositions of Examples 1 to 11 and Comparative Examples 1 to 7 was subjected to primary crosslinking and secondary crosslinking to prepare an AS-214 O-ring test piece of a rubber composition. Each test piece was set in a plasma processing system (manufactured by SHINKO SEIKI CO., LTD.), and was exposed for 30 minutes to plasma generated at a frequency of 2.45 GHz, a pressure of 100 Pa, a power of 1500 W, and a total gas flow rate of 510 mL/min using a mixed gas obtained by mixing $O_2$ gas and $CF_4$ gas at a volume ratio of 2:1. At

EP 4 763 920 A1

that time, the presence or absence of dust generation was visually confirmed. In addition, a mass loss rate and a mass loss ratio were calculated based on the following formulas, and the mass loss ratio was evaluated as A when it was less than 1.1 and as B when it was 1.1 or more. An AS-214 O-ring made of a ternary FKM was used as a standard test piece. This standard test piece was also exposed to plasma under the same conditions as described above to calculate the mass loss rate.

Mass loss rate (%) = (difference in test piece mass before and after exposure/test piece mass before exposure) × 100

$$\text{Mass loss ratio} = \text{mass loss rate/mass loss rate of standard test piece}$$

INDUSTRIAL APPLICABILITY

The present invention is useful in the technical field of uncrosslinked rubber compositions and rubber molded articles using the same.

**Claims**

1.  An uncrosslinked rubber composition comprising:

    a base rubber mainly composed of a silicone rubber;
    a perfluoro-skeleton compound having an ethylenically unsaturated bond; and
    a first silica, wherein
    a mass ratio of an amount of the perfluoro-skeleton compound to an amount of the first silica is less than 5.

2.  The uncrosslinked rubber composition according to claim 1, wherein
    the base rubber includes phenyl vinyl methyl silicone rubber.

3.  The uncrosslinked rubber composition according to claim 1 or 2, wherein
    the perfluoro-skeleton compound includes a one-component liquid material.

4.  The uncrosslinked rubber composition according to claim 3, wherein
    a viscosity of the one-component liquid material as the perfluoro-skeleton compound at 23°C is 350 Pa·s or more and 450 Pa·s or less.

5.  The uncrosslinked rubber composition according to any one of claims 1 to 4, wherein
    the first silica includes a dry-process silica.

6.  The uncrosslinked rubber composition according to any one of claims 1 to 5, wherein
    the uncrosslinked rubber composition is prepared using a rubber compound in which a second silica is mixed in advance with the silicone rubber.

7.  The uncrosslinked rubber composition according to claim 6, wherein
    the amount of the perfluoro-skeleton compound is 3 parts by mass or more and 40 parts by mass or less per 100 parts by mass of the rubber compound.

8.  The uncrosslinked rubber composition according to claim 6 or 7, wherein
    the amount of the first silica is 2 parts by mass or more and 25 parts by mass or less per 100 parts by mass of the rubber compound.

9.  The uncrosslinked rubber composition according to any one of claims 1 to 8, further comprising an organic peroxide.

10. The uncrosslinked rubber composition according to claim 9, wherein
    the organic peroxide includes a dialkyl peroxide.

9

11. A rubber molded article obtained by molding the uncrosslinked rubber composition according to any one of claims 1 to 10 into a predetermined shape and crosslinking the molded composition.

12. The rubber molded article according to claim 11, wherein
the rubber molded article is a seal.

13. The rubber molded article according to claim 12, wherein
the seal is a seal for a semiconductor manufacturing apparatus.

## INTERNATIONAL SEARCH REPORT

| International application No. |
| --- |
| **PCT/JP2024/028073** |

### A. CLASSIFICATION OF SUBJECT MATTER

*C08L 83/04*(2006.01)i; *C08K 3/36*(2006.01)i; *C08K 5/14*(2006.01)i; *C08L 83/07*(2006.01)i; *C08L 101/04*(2006.01)i; *C09K 3/10*(2006.01)i; *F16J 15/10*(2006.01)i; *H01L 21/3065*(2006.01)i
FI:    C08L83/04; C08K3/36; C08K5/14; C08L83/07; C08L101/04; C09K3/10 G; F16J15/10 G; H01L21/302 101G

According to International Patent Classification (IPC) or to both national classification and IPC

### B. FIELDS SEARCHED

Minimum documentation searched (classification system followed by classification symbols)

C08L1/00-101/16; C08K3/00-13/08; C09K3/10; F16J15/00-15/56; H01L21/00-21/98

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

CAplus/REGISTRY (STN)

### C. DOCUMENTS CONSIDERED TO BE RELEVANT

| Category* | Citation of document, with indication, where appropriate, of the relevant passages | Relevant to claim No. |
| --- | --- | --- |
| X | CN 112812566 A (AEROSPACE RESEARCH INSTITUTE OF MATERIALS AND PROCESSING TECHNOLOGY) 18 May 2021 (2021-05-18) claims, examples (for instance, example 1), etc. | 1-13 |
| X | JP 3-14838 A (SHIN-ETSU CHEMICAL CO., LTD.) 23 January 1991 (1991-01-23) claims, "industrial field of application", examples (for instance, "5" of table 1), etc. | 1-13 |
| X | JP 1-103636 A (JAPAN SYNTHETIC RUBBER CO., LTD.) 20 April 1989 (1989-04-20) claims, examples (for instance, example 6), etc. | 1-13 |
| A | JP 2006-161032 A (SHIN-ETSU CHEMICAL CO., LTD.) 22 June 2006 (2006-06-22) | 1-13 |
| A | JP 11-5902 A (SHIN-ETSU CHEMICAL CO., LTD.) 12 January 1999 (1999-01-12) | 1-13 |
| A | JP 1-198646 A (JAPAN SYNTHETIC RUBBER CO., LTD.) 10 August 1989 (1989-08-10) | 1-13 |
| A | JP 2020-37629 A (SHIN-ETSU CHEMICAL CO., LTD.) 12 March 2020 (2020-03-12) | 1-13 |

☐ Further documents are listed in the continuation of Box C.       ☑ See patent family annex.

| | | | |
| --- | --- | --- | --- |
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | "&" | document member of the same patent family |
| "P" | document published prior to the international filing date but later than the priority date claimed | | |

| Date of the actual completion of the international search | Date of mailing of the international search report |
| --- | --- |
| **16 October 2024** | **29 October 2024** |

| Name and mailing address of the ISA/JP | Authorized officer |
| --- | --- |
| **Japan Patent Office (ISA/JP)** <br> **3-4-3 Kasumigaseki, Chiyoda-ku, Tokyo 100-8915** <br> **Japan** | |
| | Telephone No. |

Form PCT/ISA/210 (second sheet) (July 2022)

## INTERNATIONAL SEARCH REPORT
### Information on patent family members

International application No.

**PCT/JP2024/028073**

| Patent document cited in search report | | | Publication date (day/month/year) | Patent family member(s) | | | Publication date (day/month/year) |
|---|---|---|---|---|---|---|---|
| CN | 112812566 | A | 18 May 2021 | (Family: none) | | | |
| JP | 3-14838 | A | 23 January 1991 | US | 5204408 | A | |
| | | | | claims, column 1, lines 7-10, examples (for instance, "5" of table 1), etc. | | | |
| JP | 1-103636 | A | 20 April 1989 | US | 5010137 | A | |
| | | | | claims, examples (for instance, example 6), etc. | | | |
| | | | | EP | 279414 | A2 | |
| | | | | KR | 10-1988-0010065 | A | |
| JP | 2006-161032 | A | 22 June 2006 | US | 2006/0100343 | A1 | |
| | | | | EP | 1657282 | A1 | |
| JP | 11-5902 | A | 12 January 1999 | (Family: none) | | | |
| JP | 1-198646 | A | 10 August 1989 | US | 4942202 | A | |
| JP | 2020-37629 | A | 12 March 2020 | (Family: none) | | | |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 5083489 B
- JP H115902 A